# FASCICULE DE BREVET EUROPEEN

(11) **EP 3 158 562 B1**
(45) Date de publication et mention de la délivrance du brevet: **18.07.2018**
(21) Numéro de dépôt: 15735990.2
(22) Date de dépôt: 08.06.2015
(51) Int. Cl.: G11C 14/00, G11C 19/28

(54) **REGISTRE AYANT UNE MÉMOIRE NON VOLATILE POUR LA SAUVEGARDE ET LA RESTAURATION D'UNE MÉMOIRE VOLATILE**
REGISTER MIT NICHTFLÜCHTIGEM SPEICHER ZUR SICHERUNG UND WIEDERHERSTELLUNG VON FLÜCHTIGEM SPEICHER
REGISTER HAVING NON-VOLATILE MEMORY FOR BACKING UP AND RESTORING VOLATILE MEMORY

(30) Priorité: 17.06.2014 FR 1455558
(43) Date de publication de la demande: 26.04.2017
(73) Titulaire: Commissariat à l'Energie Atomique et aux Energies Alternatives, 75015 Paris (FR); Centre National de la Recherche Scientifique, 75794 Paris Cedex 16 (FR)
(72) Inventeur: PAOLI, Pierre, F-38000 Grenoble (FR); LAYER, Christophe, F-38000 Grenoble (FR); JAVERLIAC, Virgile, F-38100 Grenoble (FR); NOZIERES, Jean-Pierre, F-38700 Le Sappey en Chartreuse (FR)
(74) Mandataire: Cabinet Beaumont
(86) Numéro de dépôt international: PCT/FR2015/051509
(87) Numéro de publication internationale: WO 2015/193582

(56) Documents cités:
- US-A- 4 523 295
- US-A1- 2011 122 709
- US-A1- 2013 194 867
- US-A1- 2014 149 773

## Description

### Domaine

La présente demande concerne le domaine des registres, et en particulier un registre à mémorisation combinée volatile et non volatile.

### Exposé de l'art antérieur

Il a déjà été proposé d'utiliser des éléments magnétorésistifs dans des cellules mémoires pour assurer une mémorisation non volatile de données. De tels éléments sont programmables pour prendre l'un de deux états résistifs différents. L'état résistif programmé est conservé même lorsqu'une tension d'alimentation de la cellule mémoire est déconnectée, et ainsi des données peuvent être mémorisées de façon non volatile par de tels éléments.

Divers types d'éléments magnétorésistifs ont été proposés, dont certains peuvent être programmés par le sens d'un courant que l'on fait passer dans l'élément. Un exemple d'un tel élément magnétorésistif programmable par un courant est une jonction tunnel magnétique ayant un mécanisme d'écriture basé sur la technique STT (couple de transfert de spin).

Des registres comprenant un certain nombre de cellules mémoires, comme des bascules de type D, fournissent un moyen de mémoriser des données qui peuvent être accédées rapidement, et avec une consommation d'énergie relativement faible.

Le document US2014/149773 décrit un circuit de verrouillage comprenant un élément résistif commutable et un circuit de commutation configuré pour régler l'élément résistif commutable. Toutefois, on a besoin dans la technique d'un nouveau type de registre mémoire assurant un accès rapide aux données tout en assurant aussi une mémorisation non volatile de données, et sans augmenter de façon significative la surface ou la consommation d'énergie.

### Résumé

Un objet de modes de réalisation de la présente description est de répondre au moins en partie à un ou plusieurs besoins de l'art antérieur.

Selon un aspect de la présente description, on prévoit un registre comprenant une pluralité de cellules de mémoire volatile comportant chacune une première entrée et une sortie, les cellules de mémoire volatile étant couplées en série entre elles par l'intermédiaire de leurs premières entrées et de leurs sorties ; une mémoire non volatile comprenant une pluralité de cellules de mémoire non volatile ; et une ou plusieurs connexions en série, dans lequel la mémoire non volatile comprend : soit une paire de circuits d'écriture commune pour la pluralité de cellules de mémoire non volatile, et un circuit de lecture associé à chacune des cellules de mémoire non volatile, chaque circuit de lecture ayant sa sortie couplée en parallèle avec l'une correspondante des cellules de mémoire volatile, l'une ou plusieurs connexions en série étant adaptées à fournir en série à la mémoire non volatile des données à écrire dans la mémoire non volatile à partir d'une dernière ou d'une autre des cellules de mémoire volatile pendant une opération de sauvegarde de données mémorisées par les cellules de mémoire volatile ; soit un circuit de lecture commun pour la pluralité de cellules de mémoire non volatile et une paire de circuits d'écriture associée à chacune des cellules de mémoire non volatile, chaque circuit d'écriture étant contrôlé sur la base de l'une correspondante des sorties des cellules de mémoire volatile pour programmer une valeur de donnée dans la cellule de mémoire non volatile correspondante, l'une ou plusieurs connexions en série étant adaptées à fournir en série des données lues dans la mémoire non volatile à une première des cellules de mémoire volatile pendant une opération de restauration des données mémorisées par les cellules de mémoire volatile.

Selon un aspect de la présente description, on prévoit un registre comprenant : une pluralité de cellules de mémoire volatile comportant chacune une première entrée et une sortie, les cellules de mémoire volatile étant couplées en série entre elles par l'intermédiaire de leurs premières entrées et de leurs sorties ; une mémoire non volatile comprenant une pluralité de cellules de mémoire non volatile ; et une ou plusieurs connexions en série adaptées à réaliser au moins l'une des fonctions suivantes : fournir en série à la mémoire non volatile des données à écrire dans la mémoire non volatile à partir d'une dernière ou d'une autre des cellules de mémoire volatile pendant une opération de sauvegarde de données mémorisées par les cellules de mémoire volatile ; et fournir en série des données lues dans la mémoire non volatile à une première des cellules de mémoire volatile pendant une opération de restauration des données mémorisées par les cellules de mémoire volatile.

Selon un mode de réalisation, chacune des cellules de mémoire volatile comprend en outre une deuxième entrée pour recevoir des données à mémoriser dans le registre, et une entrée de sélection pour sélectionner l'une des première et deuxième entrées.

Selon un mode de réalisation, le registre comprend un bloc de commande adapté à contrôler l'entrée de sélection de chacune des cellules de mémoire volatile pour sélectionner la première entrée pendant l'opération de restauration et/ou l'opération de sauvegarde.

Selon un mode de réalisation, lesdites une ou plusieurs connexions en série sont en outre adaptées à introduire des données de test par balayage en série dans la première des cellules de mémoire volatile pendant une opération de test par balayage.

Selon un mode de réalisation, le registre comprend en outre une ligne de retour couplant la sortie de la dernière des cellules de mémoire volatile à la première entrée de la première des cellules de mémoire volatile.

Selon un mode de réalisation, les sorties des cellules de mémoire volatile sont couplées en parallèle à des entrées correspondantes de la mémoire non volatile.

Selon un mode de réalisation, la mémoire non volatile comprend : un circuit de lecture commun pour la pluralité de cellules de mémoire non volatile ; et une paire de circuits d'écriture associée à chacune des cellules de mémoire non volatile, chaque circuit d'écriture étant contrôlé sur la base de l'une correspondante des sorties des cellules de mémoire volatile pour programmer une valeur de donnée dans la cellule de mémoire non volatile correspondante.

Selon un mode de réalisation, la mémoire non volatile comprend : une paire de circuits d'écriture commune pour la pluralité de cellules de mémoire non volatile ; et un circuit de lecture associé à chacune des cellules de mémoire non volatile, chaque circuit de lecture ayant sa sortie couplée en parallèle avec l'une correspondante des cellules de mémoire volatile.

Selon un mode de réalisation, lesdites une ou plusieurs connexions en série sont adaptées à fournir les données lues dans la mémoire non volatile en série à la première des cellules de mémoire volatile pendant l'opération de restauration et à fournir les données à écrire dans la mémoire non volatile, en série à partir de la dernière ou d'une autre des cellules de mémoire volatile, à la mémoire non volatile pendant une opération de sauvegarde.

Selon un mode de réalisation, la mémoire non volatile comprend : un circuit de lecture commun pour la pluralité de cellules de mémoire non volatile ; et une paire de circuits d'écriture commune pour la pluralité de cellules de mémoire non volatile.

Selon un mode de réalisation, chacune de la pluralité de cellules de mémoire non volatile comprend : des premier et deuxième éléments résistifs, dont au moins l'un est programmable pour prendre l'un d'au moins deux états résistifs, une valeur de donnée étant représentée par les résistances relatives des premier et deuxième éléments résistifs, le premier élément résistif étant couplé entre un premier noeud intermédiaire et un premier noeud de mémorisation d'un circuit de lecture et le deuxième élément résistif étant couplé entre un deuxième noeud intermédiaire et un deuxième noeud de mémorisation.

Selon un mode de réalisation, au moins l'un des premier et deuxième éléments résistifs est de l'un des types suivants : un élément à couple de transfert de spin ayant une anisotropie dans le plan ; un élément à couple de transfert de spin ayant une anisotropie perpendiculaire au plan ; un élément à oxydoréduction ; un élément ferroélectrique ; et un élément à changement de phase.

Selon un autre aspect de la présente description, on prévoit un procédé de sauvegarde de données dans le registre mémoire susmentionné, comprenant : fournir en série, par lesdites une ou plusieurs connexions en série, des données à écrire dans la mémoire non volatile à partir de la dernière ou d'une autre des cellules de mémoire volatile.

Selon un autre aspect de la présente description, on prévoit un procédé restauration de données dans le registre mémoire susmentionné, comprenant : fournir en série à la première des cellules de mémoire volatile, par lesdites une ou plusieurs connexions en série, des données lues dans la mémoire non volatile.

### Brève description des dessins

Les caractéristiques et avantages susmentionnés, et d'autres, apparaîtront clairement avec la description détaillée suivante de modes de réalisation, donnés à titre d'illustration et non de limitation, en référence aux dessins joints, dans lesquels :
la figure 1 illustre schématiquement un registre selon un exemple de réalisation de la présente description ;
la figure 2 illustre schématiquement plus en détail une mémoire non volatile du registre de la figure 1 selon un exemple de réalisation de la présente description ;
la figure 3 est un chronogramme représentant des exemples de signaux dans le registre de la figure 1 et dans la mémoire non volatile de la figure 2, pendant une opération de sauvegarde selon un exemple de réalisation de la présente description ;
la figure 4 est un chronogramme représentant des exemples de signaux dans le registre de la figure 1 et dans la mémoire non volatile de la figure 2 pendant une opération de restauration selon un exemple de réalisation de la présente description ;
la figure 5 illustre schématiquement plus en détail la mémoire non volatile de la figure 1 selon un autre exemple de réalisation de la présente description ;
la figure 6 illustre schématiquement plus en détail le registre de la figure 1 selon un autre exemple de réalisation de la présente description ; et
les figures 7A et 7B illustrent des éléments résistifs basés sur des jonctions tunnel magnétiques selon des exemples de réalisation de la présente description.

### Description détaillée

Dans la description suivante, le terme « connecté » est utilisé pour faire référence à une connexion directe entre un élément et un autre, alors que le terme « couplé » implique que la connexion entre les deux éléments peut être directe, ou se faire via un élément intermédiaire, comme un transistor, une résistance ou un autre composant.

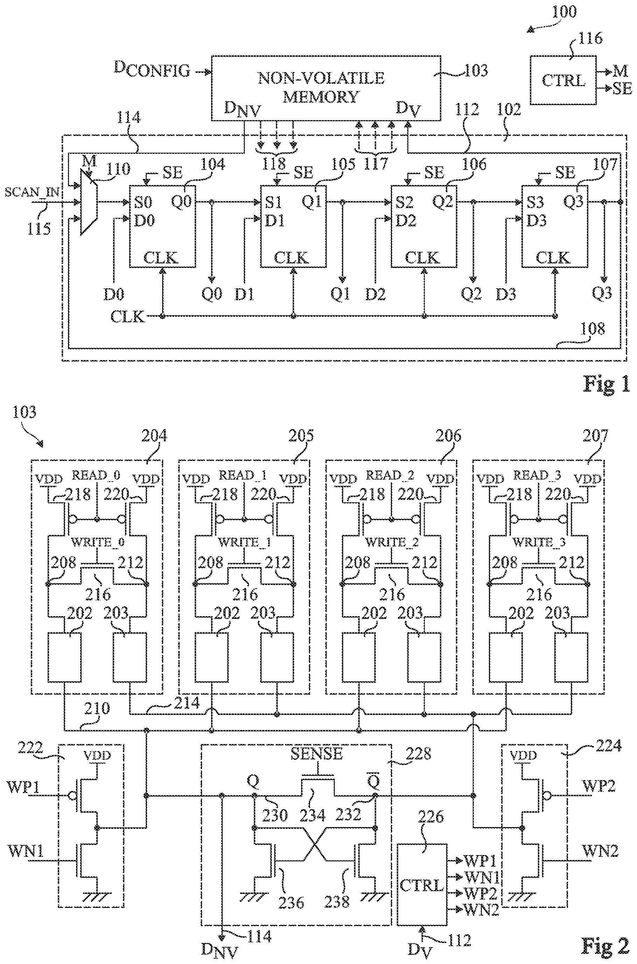

La figure 1 illustre schématiquement un registre combiné à mémorisation volatile/non volatile 100 selon un exemple de réalisation. Le registre 100 comprend une portion volatile 102 comprenant une pluralité de cellules de mémoire volatile, et une mémoire non volatile (NON VOLATILE MEMORY) 103.

Dans l'exemple de la figure 1, la portion volatile 102 comprend quatre cellules de mémoire volatile 104 à 107, bien que dans des variantes de réalisation elle puisse en comprendre un nombre différent, par exemple deux ou plus. Les cellules volatiles 104 à 107 sont par exemple des bascules de type D ou d'autres types de dispositifs mémoires synchrones contrôlés par un signal d'horloge CLK et capables chacun de mémoriser un bit de données. Les cellules volatiles sont couplées en série pour former une chaîne. Par exemple, les cellules de mémoire volatile 104 à 107 comprennent des entrées S0 à S3 respectivement et des sorties Q0 à Q3 respectivement, et elles sont couplées en série par l'intermédiaire de ces entrées et de ces sorties. En particulier, la sortie Q0 de la cellule volatile 104 est par exemple couplée à l'entrée S1 de la cellule volatile 105, la sortie Q1 de la cellule volatile 105 est couplée à l'entrée S2 de la cellule volatile 106, et ainsi de suite. La sortie de la cellule volatile finale 107 dans la chaîne est par exemple couplée par l'intermédiaire d'une ligne de retour 108 à la première cellule volatile 104. La ligne de retour 108 est par exemple couplée à une entrée d'un multiplexeur 110, la sortie du multiplexeur 110 étant couplée à l'entrée S0 de la cellule volatile 104.

Les sorties Q0 à Q3 des cellules volatiles 104 à 107 fournissent aussi par exemple des signaux de données correspondants Q0 à Q3 à un ou plusieurs autres circuits (non illustrés en figure 1). Les cellules volatiles comprennent par exemple en outre des entrées D0 à D3 respectivement, pour recevoir des signaux de données correspondants D0 à D3 à mémoriser dans le registre mémoire 100. Les signaux de données D0 à D3 sont par exemple fournis par un ou plusieurs autres circuits (non illustrés en figure 1). En outre, chaque cellule volatile 104 à 107 est par exemple contrôlée par un signal de sélection SE pour sélectionner soit l'entrée S0 à S3 correspondante soit l'entrée D0 à D3 correspondante.

La sortie Q3 de la cellule volatile 107 est par exemple couplée à une entrée D_{V} de la mémoire non volatile 103 par l'intermédiaire d'une ligne 112. Le multiplexeur 110 a par exemple une autre de ses entrées couplée à une sortie D_{NV} de la mémoire non volatile 103 par l'intermédiaire d'une ligne 114. Le multiplexeur 110 a aussi par exemple une troisième entrée couplée à une ligne d'entrée 115 pour recevoir un signal de données de test SCAN_IN. Le multiplexeur 110 est par exemple contrôlé par un signal M en fonction du mode de fonctionnement du registre 100, comme cela va être décrit plus en détail ci-après. Les signaux de commande M et SE sont par exemple fournis par un bloc de commande (CTRL) 116.

La mémoire non volatile 103 comprend par exemple une pluralité de cellules de mémoire non volatile (non illustrées en figure 1), chacune mémorisant un bit de données de façon non volatile. Dans certains modes de réalisation, les cellules de mémoire non volatile comprennent des éléments magnétorésistifs. La mémoire non volatile 103 comprend par exemple une entrée destinée à recevoir des données de configuration D_{CONFIG} permettant à la mémoire non volatile 103 d'être programmée indépendamment des données mémorisées dans la portion volatile 102 du registre 100.

Le registre 100 est par exemple capable de fonctionner dans l'un des trois modes de fonctionnement principaux suivants : un mode de test ; un mode actif standard ; et un mode de veille.

Dans le mode de test, le bloc de commande 116 génère des signaux de commande SE et M qui commandent le multiplexeur 110 pour sélectionner le signal de test par balayage SCAN_IN et les cellules volatiles 104 à 107 pour sélectionner les entrée S0 à S3 correspondantes. Le signal de test par balayage SCAN_IN est ainsi appliqué à la chaîne de cellules volatiles, et l'un des signaux de sortie Q0 à Q3 est par exemple vérifié pour s'assurer d'un fonctionnement correct du registre.

Dans le mode actif standard, le registre 100 est par exemple utilisé pour mémoriser le signal de données D0 à D3 d'une façon volatile en utilisant les cellules de mémoire volatile 104 à 107. Ainsi, pendant le mode actif standard, le bloc de commande 116 génère le signal de commande SE qui contrôle les cellules volatiles 104 à 107 pour sélectionner les entrées D0 à D3 correspondantes.

Dans le mode de veille, le registre 100 a par exemple son alimentation coupée pour économiser l'énergie. Ainsi, dans le mode de veille, les données mémorisées par la portion volatile 102 du registre 100 sont perdues, et seules les données mémorisées par la mémoire non volatile 103 sont conservées. Périodiquement, pendant que le registre 100 est dans le mode actif standard, et/ou juste avant que le registre 100 ne passe dans le mode de veille, une opération de sauvegarde est réalisée de sorte que les données mémorisées par les cellules volatiles 104 à 107 sont mémorisées dans la mémoire non volatile 103. En outre, lorsque l'on quitte le mode de veille, une opération de restauration est par exemple réalisée pour recharger les données de la mémoire non volatile 103 dans les cellules volatiles 104 à 107.

Pendant les opérations de sauvegarde et de restauration, le bloc de commande 116 génère le signal de commande SE pour contrôler les cellules volatiles 104 à 107 pour sélectionner les entrées S0 à S3 respectivement, de sorte les cellules volatiles sont couplées en série. Au moins l'une des opérations de sauvegarde et de restauration est ensuite réalisée en série, transférant des données en série entre les cellules volatiles et la mémoire non volatile du registre. Par exemple, pendant une opération de sauvegarde, des données sont fournies en série par l'intermédiaire de la connexion série assurée par la ligne 112 à partir de la cellule volatile 107 vers la mémoire non volatile 103 du registre 100. En plus, ou à la place, pendant une opération de restauration, des données sont introduites en série par l'intermédiaire de la connexion série assurée par la ligne 114 et le multiplexeur 110, à partir de la mémoire non volatile 103 vers la cellule volatile 104.

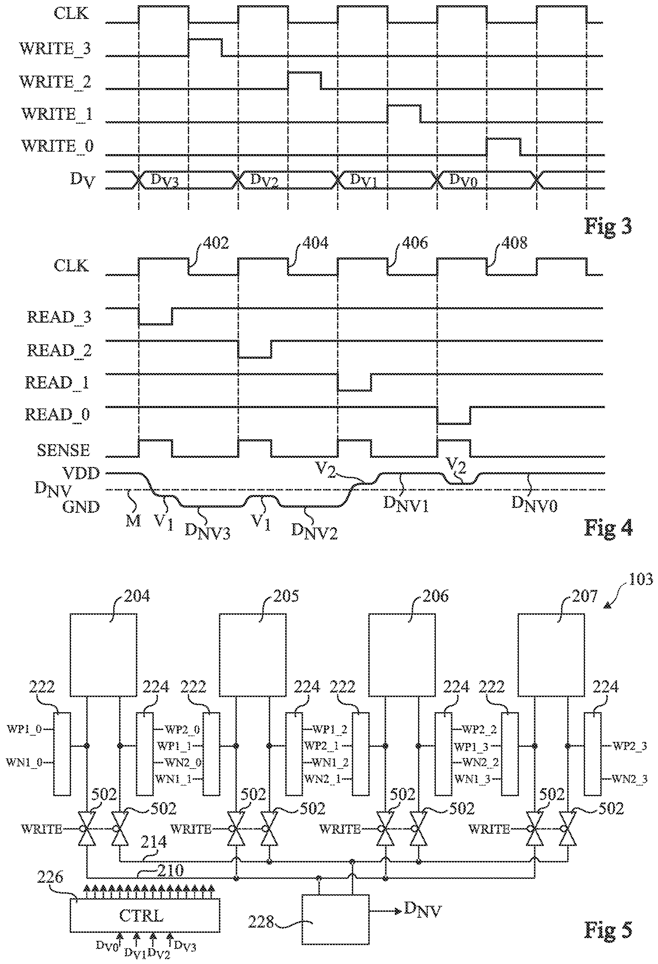

Il apparaîtra clairement à l'homme de l'art que, plutôt que la ligne 112 soit couplée à la sortie de la cellule volatile 107, elle pourrait être couplée à la sortie de l'une quelconque des autres cellules volatiles. En outre, comme cela est représenté par des flèches en pointillés 117 en figure 1, dans certains modes de réalisation, les données au niveau des sorties Q0 à Q3 des cellules volatiles 104 à 107 sont écrites dans la mémoire non volatile 103 en parallèle pendant une opération de sauvegarde. Un exemple d'un tel mode de réalisation va être décrit ci-après en référence à la figure 5.

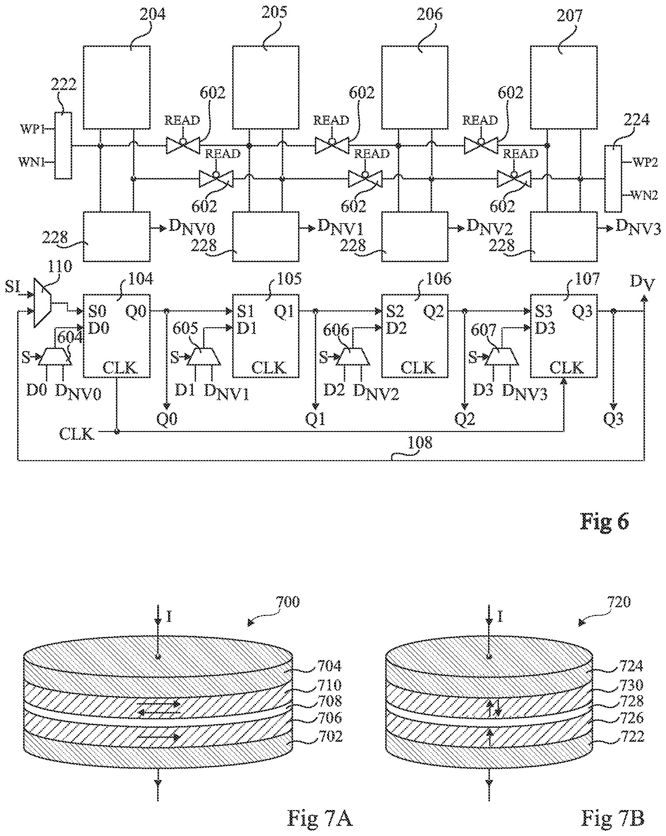

Il apparaîtra également clairement à l'homme de l'art que, plutôt que la ligne 114 soit couplée par l'intermédiaire du multiplexeur 110 à une entrée de la cellule volatile 104, elle pourrait être couplée à une entrée de l'une quelconque des autres cellules volatiles, par exemple, par l'intermédiaire d'un multiplexeur correspondant. En outre, comme cela est représenté par des flèches en pointillés 118 en figure 1, dans certains modes de réalisation, les données lues dans la mémoire non volatile 103 pourraient être fournies en parallèle aux cellules volatiles 104 à 107 pendant une opération de restauration. Un exemple d'un tel mode de réalisation va être décrit ci-après en référence à la figure 6.

La figure 2 illustre schématiquement plus en détail la mémoire non volatile 103 selon un exemple de réalisation dans lequel des données sont écrites et lues dans la mémoire non volatile 103 en série, uniquement par l'intermédiaire des lignes 112 et 114.

La mémoire non volatile 103 comprend par exemple une pluralité de cellules de mémoire non volatile comprenant chacune une paire d'éléments résistifs programmables 202, 203. Dans l'exemple de la figure 2, il y a quatre cellules non volatiles 204 à 207, mais dans des variantes de réalisation, il pourrait y en avoir un nombre quelconque. Dans certains modes de réalisation, il y a le même nombre de cellules non volatiles que le nombre de cellules volatiles dans la portion volatile 102 du registre 100.

Chacun des éléments résistifs 202, 203 peut être programmé pour prendre l'un d'une pluralité d'états résistifs. Les éléments résistifs 202, 203 sont des éléments à commutation de résistance d'un type quelconque, comme des éléments magnétorésistifs. Dans certains modes de réalisation, les éléments 202, 203 sont du type ayant une résistance programmable par la direction d'un courant que l'on fait passer dedans. Comme on va le décrire plus en détail ci-après en référence aux figures 7A et 7B, les éléments à commutation de résistance 202, 203 sont par exemple des éléments à couple de transfert de spin ayant une anisotropie dans le plan ou perpendiculaire au plan, comme cela est décrit plus en détail dans la publication intitulée "Magnonic spin-transfer torque MRAM with low power, high speed, and error-free switching", N.Mojumder et al., IEDM Tech. Digest (2010), et dans la publication intitulée "Electric toggling of magnets", E. Tsymbal, Natural Materials Vol 11, Janvier 2012. En variante, les éléments 202, 203 pourraient être du type utilisé dans des mémoires RAM à commutation de résistance RedOx (RAM à oxydo-réduction), qui sont par exemple décrites plus en détail dans la publication intitulée "Redox-Based Resistive Switching Memories - Nanoionic Mechanisms, Prospects and Challenges", Rainer Waser et al., Advanced Materials 2009, 21, pages 2632 to 2663. Dans encore un autre exemple, les éléments résistifs pourraient être ceux utilisés dans une FeRAM (RAM Ferroélectrique) ou dans une PCRAM (RAM à changement de phase).

Quel que soit le type d'élément résistif, un bit de données est par exemple mémorisé d'une manière non volatile dans les cellules non volatiles 204 à 207 en mettant l'un des éléments résistifs à une résistance relativement élevée (Rₘₐₓ), et l'autre à une résistance relativement basse (Rₘᵢₙ). Chacun des éléments résistifs 202, 203 a par exemple seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions comme le processus de fabrication, les matériaux, les variations de température etc...

Le bit de donnée non volatile représenté par les éléments résistifs 202, 203 dépend duquel des éléments résistifs a la résistance Rₘₐₓ ou Rₘᵢₙ, en d'autres termes, des résistances relatives. Les éléments résistifs 202, 203, sont par exemple sélectionnés de telle sorte que la résistance Rₘₐₓ soit toujours notablement supérieure à la résistance Rₘᵢₙ, par exemple supérieure d'au moins 20 %. En général, le rapport entre la résistance Rₘₐₓ et la résistance Rₘᵢₙ est par exemple compris entre 1,2 et 10 000. La résistance Rₘᵢₙ est par exemple dans la région des deux kilo-ohms ou moins, et la résistance Rₘₐₓ est par exemple dans la région des 6 kilo-ohms ou plus, bien que de nombreuses autres valeurs soient possibles.

Il sera clair pour l'homme de l'art que dans certains modes de réalisation, plutôt que les deux éléments résistifs 202, 203 soient programmables, un seul soit programmable. Dans un tel cas, l'autre élément résistif a par exemple une résistance fixe à un niveau intermédiaire situé environ à mi-chemin entre Rₘᵢₙ et Rₘₐₓ, par exemple égal, avec une tolérance de 10 %, à (Rₘᵢₙ+(Rₘₐₓ-Rₘᵢₙ)/2). Par exemple, l'un des éléments résistifs 202, 203, pourrait correspondre à une résistance de valeur fixe. En variante, l'un des éléments résistifs 202, 203 pourrait être constitué de deux éléments résistifs programmables couplés en parallèle et ayant des orientations opposées, de sorte que quel que soit le sens dans lequel chaque élément est programmé, la valeur de résistance reste relativement constante au niveau intermédiaire.

L'élément résistif 202 se trouvant dans chaque cellule non volatile 204 à 207 est par exemple couplé entre un noeud intermédiaire 208 et une ligne commune 210 des cellules non volatiles. De façon similaire, l'élément résistif 203 est par exemple couplé entre un noeud intermédiaire 212 et une ligne commune 214 des cellules non volatiles. Les noeuds intermédiaires 208 et 212 sont couplés entre eux par l'intermédiaire des noeuds de courant principaux d'un transistor 216, qui est par exemple un transistor MOS à canal N (NMOS) . Les noeuds de commande des transistors 216 des cellules non volatiles 204 à 207 sont par exemple contrôlés par des signaux d'écriture correspondants WRITE_0 à WRITE_3. Le noeud intermédiaire 208 est par exemple en outre couplé à une tension d'alimentation VDD par l'intermédiaire des noeuds de courant principaux d'un transistor MOS à canal P (PMOS) 218. De façon similaire, le noeud 212 est par exemple couplé à la tension d'alimentation VDD par l'intermédiaire des noeuds de courant principaux d'un transistor PMOS 220. Les noeuds de commande des transistors PMOS 218, 220 des cellules non volatiles 204 à 207 sont par exemple contrôlés par des signaux de lecture READ 0 à READ 3 correspondants.

La mémoire non volatile 103 comprend par exemple des circuits d'écriture communs 222 et 224. En particulier, la ligne commune 210 est par exemple couplée au circuit d'écriture 222, et la ligne commune 214 est par exemple couplée au circuit d'écriture 224. Le circuit d'écriture 222 est capable de coupler la ligne commune 210 à la masse ou à la tension d'alimentation VDD en fonction d'une paire de signaux de commande WN1 et WP1. Par exemple, le circuit d'écriture 222 comprend un transistor NMOS contrôlé par le signal WN1 et couplé par ses noeuds de courant principaux entre la ligne commune 210 et la masse, et un transistor PMOS contrôlé par le signal WP1 et couplé par ses noeuds de courants principaux entre la ligne commune 210 et la tension d'alimentation VDD. De façon similaire, le circuit d'écriture 224 est capable de coupler la ligne commune 214 à la masse ou à la tension d'alimentation VDD en fonction d'une paire de signaux de commande WN2 et WP2. Par exemple, le circuit d'écriture 222 comprend un transistor NMOS contrôlé par le signal WN2 et couplé par ses noeuds de courant principaux entre la ligne commune 214 et la masse, et un transistor PMOS contrôlé par le signal WP2 et couplé par ses noeuds de courant principaux entre la ligne commune 214 et la tension d'alimentation VDD.

Les signaux WP1, WN1, WP2 et WN2 sont par exemple générés par un bloc de commande (CTRL) 226, en fonction du signal de données d'entrée D_{V} reçu sur la ligne 112 à partir de la portion de mémoire volatile 102 du registre 100.

La mémoire non volatile 103 comprend aussi par exemple un circuit de lecture commun 228 ayant un noeud de mémorisation 230 couplé à la ligne commune 210, et un noeud de mémorisation 232 couplé à la ligne commune 214. Les noeuds de mémorisation 230 et 232 sont par exemple couplés entre eux par l'intermédiaire des noeuds de courants principaux d'un transistor NMOS 234 contrôlé au niveau de son noeud de grille par un signal SENSE. Deux inverseurs sont couplés de façon croisée entre les noeuds de mémorisation 230 et 232. Chaque inverseur est par exemple constitué d'un seul transistor 236, 238 respectivement. Le transistor 236 est par exemple un transistor NMOS couplé par ses noeuds de courants principaux entre le noeud 230 et la masse. Le transistor 238 est par exemple un transistor NMOS couplé par ses noeuds de courants principaux entre le noeud de mémorisation 232 et la masse. Un noeud de commande du transistor 236 est couplé au noeud de mémorisation 232, et un noeud de commande du transistor 238 est couplé au noeud de mémorisation 230. Un état haut de la tension Q sur le noeud de mémorisation 230 ou de la tension *Q̅* sur le noeud de mémorisation 232 est maintenu par un courant de fuite passant dans le transistor PMOS 218 ou 220 de chaque cellule non volatile 204 à 207. En particulier, les tensions de seuil des transistors PMOS 218 et 220 sont par exemple choisies de façon à être inférieures à celles des transistors NMOS 236 et 238, de sorte que le courant de fuite passant à travers les transistors 218 et 220, lorsqu'ils sont dans l'état non conducteur, est supérieur au courant de fuite dans les transistors 236 ou 238 lorsqu'ils sont dans l'état non conducteur.

La figure 3 est un chronogramme représentant un exemple de signaux dans le registre 100 de la figure 1 et dans la mémoire non volatile de la figure 2 pendant une opération de sauvegarde sur la base du signal de données D_{V} provenant des cellules de mémoire volatile 104 à 107. En particulier, la figure 3 représente des exemples du signal d'horloge CLK, des signaux d'écriture WRITE_3 à WRITE_0 contrôlant les transistors 216 des cellules de mémoire non volatile 207 à 204 respectivement, et du signal de données D_{V}.

Pendant l'opération de sauvegarde, les cellules mémoires 104 à 107 sont par exemple contrôlées par le signal de sélection SE pour sélectionner les entrées S0 à S3 respectives à propager vers leurs sorties. Le signal de données D_{V} a par exemple ses transitions sur les fronts montants du signal d'horloge CLK. Ainsi, en appelant D_{V0} à D_{V3} respectivement les valeurs de données mémorisées initialement par les cellules 104 à 107 au début de la phase de sauvegarde, le signal de données D_{V} va correspondre, sur des fronts montants consécutifs du signal d'horloge CLK, aux valeurs de données D_{V3}, D_{V2}, D_{V1} et D_{V0}.

La phase d'écriture implique de faire passer un courant dans les éléments résistifs 202, 203 de chacune des cellules non volatiles 204 à 207, par l'intermédiaire du transistor 216, dans une direction ou dans l'autre en fonction de la valeur de la donnée à mémoriser. Les éléments résistifs 202, 203 de chaque cellule non volatile sont orientés de telle sorte que, pour une direction donnée du courant, ils soient programmés avec des résistances opposées.

Comme cela est illustré en figure 3, initialement les signaux d'écriture WRITE_3 à WRITE_0 sont à l'état bas, de sorte qu'aucun des transistors 216 n'est conducteur. Le terme "état haut" est utilisé ici pour désigner un niveau de tension proche de, ou égal à la tension d'alimentation V_{DD}, alors que le terme "état bas" est utilisé ici pour désigner un niveau de tension proche de, ou égal à la tension de masse. La cellule de mémoire non volatile 207 est par exemple programmée d'abord par la valeur de données D_{V3}. Ainsi, le signal d'écriture WRITE_3 par exemple passe à l'état haut sur un front descendant alors que le signal D_{V} a la valeur D_{V3}. En même temps, le bloc de commande 226 de la figure 2 génère par exemple des valeurs des signaux de commande WN1, WP1, WN2 et WP2 pour provoquer le passage d'un courant dans les éléments résistifs 202, 203, de la cellule non volatile 207 dans une direction donnée sur la base de la valeur de donnée D_{V3}. En particulier, pour générer un courant dans une direction à partir de la ligne 210 vers la ligne 214, les signaux WP1 et WN1 sont amenés à l'état bas, et les signaux WP2 et WN2 sont amenés à l'état haut. Pour générer un courant dans la direction opposée à partir de la ligne 214 vers la ligne 210, les signaux WP1 et WN1 sont amenés à l'état haut, et les signaux WP2 et WN2 sont amenés à l'état bas. Le signal WRITE_3 reste haut suffisamment longtemps pour changer les états résistifs des éléments résistifs 202, 203. Par exemple, les signaux d'écriture sont activés pendant une durée comprise entre 0,1 ns et 20 ns. Le signal D_{V} passe ensuite à la valeur D_{V2}, et le signal d'écriture WRITE_2 est activé pour faire en sorte que la cellule non volatile 206 soit programmée, et ainsi de suite, jusqu'à ce que toutes les cellules volatiles 204 à 207 aient été programmées.

Dans certains modes de réalisation, pendant l'opération de sauvegarde, le multiplexeur 110 est contrôlé de façon à sélectionner la ligne de retour 108, de sorte que, à la fin de l'opération de sauvegarde, les cellules volatiles 104 à 107 mémorisent de nouveau les valeurs de données D_{V0} à D_{V3} respectivement.

La figure 4 est un chronogramme représentant un exemple de signaux dans le registre 100 de la figure 1 dans la mémoire non volatile de la figure 2 pendant une opération de restauration. En particulier, la figure 4 représente des exemples du signal d'horloge CLK, des signaux de lecture READ_3 à READ_0 contrôlant les transistors 218 et 220 des cellules de mémoire non volatile 207 à 204 respectivement, et du signal de données D_{NV}.

Comme cela a été mentionné précédemment, l'opération de restauration correspond à une opération destinée à transférer les données représentées par les états résistifs programmés des éléments résistifs 202, 203 des cellules non volatiles 204 à 207 vers les cellules volatiles 104 à 107. Cela implique de transformer chaque valeur de donnée d'une représentation par un état résistif programmé en une représentation par des niveaux de tension Q et *Q̅* sur les noeuds de mémorisation 230, 232, du circuit de lecture 228.

Pendant l'opération de sauvegarde, les cellules mémoires 104 à 107 sont par exemple contrôlées par le signal de sélection SE pour sélectionner les entrées S0 à S3 respectives à propager vers leur sortie.

Le signal SENSE est par exemple initialement à l'état bas, de sorte que le transistor NMOS 230 du circuit de lecture 228 est non conducteur. En outre, les signaux de lecture READ_3 à READ_0 sont par exemple tous initialement à l'état haut, de sorte qu'aucun des transistors PMOS 218, 220 n'est conducteur.

On supposera en figure 4 que les bits D_{NV3} et D_{NV2} mémorisés par les cellules non volatiles 207 et 206 sont tous les deux à l'état logique "0", et que les bits D_{NV1} et D_{NV0} mémorisés par les cellules non volatiles 205 et 204 sont tous les deux à l'état logique "1".

La valeur de données D_{NV3} mémorisée par la cellule non volatile 204 est lue en premier en amenant à l'état bas le signal de lecture READ_3, par exemple sur le front montant du signal d'horloge CLK, activant ainsi les transistors 218 et 220. Ainsi, des courants sont induits dans les branches de gauche et de droite de la cellule de mémoire non volatile 207. En même temps, le signal SENSE passe par exemple à l'état haut, activant le transistor 230 du circuit de lecture, et égalisant ainsi dans une certaine mesure les tensions Q et *Q̅* sur les noeuds de mémorisation 230, 232. En raison de la différence entre les résistances programmées des éléments résistifs 202 et 203 de la cellule non volatile 207, le courant dans la branche de gauche est par exemple inférieur au courant dans la branche de droite, et cela amène par exemple la tension Q sur le noeud de mémorisation 230 à descendre et à s'établir à un niveau V₁ en-dessous d'un niveau de métastabilité M. Le niveau de métastabilité M est un niveau de tension théorique situé approximativement à mi-chemin entre les état de tension haut et bas, représentant le niveau à partir duquel il y aurait une probabilité égale que Q bascule vers l'état haut ou l'état bas. Le signal SENSE est ensuite amené à l'état bas, ce qui bloque le transistor 230 du circuit de lecture, et le signal READ_3 est amené à l'état haut, ce qui bloque les transistors 218 et 220 de la cellule 207. Le niveau de la tension Q passe ensuite à son état stable le plus proche, qui dans l'exemple de la valeur de donnée D_{NV3} est l'état bas. Cependant, il sera clair pour l'homme de l'art que le niveau V₁ et l'état stable final vont dépendre de facteurs tels que les résistances à l'état conducteur des transistors 218, 220, 236 et 238.

La valeur de donnée D_{NV3} est par exemple échantillonnée par la première cellule volatile 104 sur le front d'horloge descendant suivant, noté 402 en figure 4.

Pendant le cycle d'horloge suivant, la valeur de données D_{NV2} est lue dans la cellule non volatile 206 de manière similaire, et cette valeur est échantillonnée par la cellule volatile 104 sur le front d'horloge descendant suivant 404. La valeur de données D_{NV3} est aussi échantillonnée par la cellule volatile 105 sur ce même front d'horloge.

La valeur de données D_{NV1} est ensuite lue dans la cellule non volatile 205, et dans ce cas, la valeur de donnée est supposée être au niveau logique "1". Lorsque les signaux READ_1 et SENSE sont activés à l'état bas et haut respectivement, la tension Q passe à un niveau V₂ légèrement supérieur au niveau de métastabilité M. Lorsque les signaux READ_1 et SENSE reviennent ensuite aux états haut et bas respectivement, la tension Q passe à son état stable le plus proche, qui est l'état haut. La valeur de données D_{NV1} est échantillonnée par la cellule volatile 104 sur le front d'horloge descendant suivant 406, et les valeurs de données qui étaient maintenues par les cellules 104 et 105 sont échantillonnées par les cellules 105 et 106 respectivement.

Pendant le cycle d'horloge suivant, la valeur de donnée D_{NV0} est lue dans la cellule non volatile 204 de façon similaire, et cette valeur est échantillonnée par la cellule volatile 104 sur le front d'horloge descendant suivant 408. Les valeurs de données qui étaient maintenues par les cellules 104, 105 et 106 sont échantillonnées par les cellules 105, 106, et 107 respectivement, de telle sorte que, à la fin de l'opération de restauration, les cellules 104 à 107 mémorisent respectivement les valeurs D_{NV0} à D_{NV3}.

La figure 5 illustre schématiquement la mémoire non volatile 103 selon un exemple dans lequel l'écriture dans les cellules non volatiles 204 à 207 est réalisée en parallèle. Par conséquent, plutôt que de comprendre un seul circuit d'écriture 222 et un seul circuit d'écriture 224, une paire de circuits d'écriture 222, 224 est couplée à chacune des cellules de mémoire non volatile 204 à 207. En particulier, un circuit d'écriture correspondant 222 est couplé à l'élément résistif 202 de chaque cellule de mémoire non volatile 204 à 207, et contrôlé par des signaux de commande correspondants WP1_n et WN1_n, avec n égal à 0 à 3 pour les cellules 204 à 207 respectivement. De façon similaire, le circuit d'écriture correspondant 224 est couplé à l'élément résistif 204 de chaque cellule mémoire non volatile 204 à 207, et contrôlé par des signaux de commande correspondants WP2_n and WN2 n, avec n égal à 0 à 3 pour les cellules 204 à 207 respectivement. Le circuit de commande 226 de la figure 2 est remplacé en figure 5 par un circuit de commande 226 adapté à générer les seize signaux de commande sur la base des valeurs de données D_{V0}, D_{V1}, D_{V2} and D_{V3}.

Le circuit de lecture commun 228 est utilisé pour lire les valeurs de données D_{NV} mémorisées par les cellules non volatiles 204 à 207. Toutefois, la ligne commune 210 située au niveau d'une entrée du circuit de lecture 228 est par exemple isolée de l'élément résistif 202 de chaque cellule 204 à 207 par des commutateurs correspondants 502, et la ligne commune 214 située au niveau de l'autre entrée du circuit de lecture 228 est par exemple isolée de l'élément résistif 203 de chaque cellule 204 à 207 par des commutateurs 502 correspondants. Les commutateurs 502 sont par exemple contrôlés par un signal d'écriture WRITE qui reste haut pendant l'opération de sauvegarde de sorte que les commutateurs 502 sont non conducteurs.

La figure 6 illustre schématiquement la mémoire non volatile 103 selon un exemple dans lequel la lecture dans les cellules non volatiles 204 à 207 est réalisée en parallèle. Par conséquent, plutôt que de comprendre un seul circuit de lecture 228, un circuit de lecture 228 correspondant est couplé à chacune des cellules de mémoire non volatile 204 à 207. En outre, plutôt que d'être couplées aux lignes communes 210 et 214, les sorties des cellules de mémoire volatile 204 à 207 sont par exemple couplées entre elles par l'intermédiaire de commutateurs 602 de sorte qu'elles peuvent être isolées l'une de l'autre pendant l'opération de restauration.

La portion volatile 102 du registre 100 comprend par exemple des multiplexeurs 604 à 607 ayant leurs sorties respectivement couplées aux entrées D0 à D3 des cellules volatiles 104 à 107. Les multiplexeurs 604 à 607 reçoivent sur l'une de leurs entrées les valeurs de données D_{NV0}, D_{NV1}, D_{NV2} et D_{NV3} respectivement, lues par les circuits de lecture 228 dans les cellules non volatiles 204 à 207. Une autre entrée de chaque multiplexeur 604 à 607 reçoit le signal de données D0 à D3 correspondant. Un signal de sélection S vers chaque multiplexeur 604 à 607 contrôle la sélection de la ligne d'entrée, et est par exemple contrôlé pendant l'opération de restauration pour sélectionner la valeur de donnée D_{NV0}, D_{NV1}, D_{NV2} et D_{NV3} lue dans la mémoire non volatile 103.

Les figures 7A et 7B illustrent les structures des éléments résistifs 202, 203 selon des exemples dans lesquels ce sont des éléments résistifs à couple de transfert de spin (STT).

La figure 7A illustre un élément résistif STT 700 ayant une anisotropie magnétique dans le plan. L'élément 700 est par exemple sensiblement cylindrique, mais a une section qui est non circulaire, par exemple ovale, ce qui conduit par exemple à une augmentation de la stabilité de rétention des états résistifs lorsque le dispositif est programmé. L'élément 700 comprend des électrodes inférieure et supérieure 702 et 704, chacune ayant sensiblement une forme de disque, prenant en sandwich entre elles un certain nombre de couches intermédiaires. Les couches intermédiaires comprennent, du bas vers le haut, une couche fixe 706, une barrière d'oxydation 708 et une couche de mémorisation 710.

La barrière d'oxydation 708 est par exemple constituée de MgO ou de AlₓO_{y}. La couche fixe 706 et la couche de mémorisation 710 sont par exemple en matériau ferromagnétique, comme du CoFe. La direction de spin de la couche fixe 706 est fixe, comme cela est représenté par une flèche de la gauche vers la droite en figure 7A. Bien-sûr, dans des variantes de réalisation la direction de spin pourra être de la droite vers la gauche dans la couche fixe 706. Toutefois, la direction de spin dans la couche de mémorisation 710 peut être changée, comme cela est représenté par des flèches dans des directions opposées en figure 7A. La direction de spin est programmée par la direction du courant d'écriture I qu'on fait passer dans l'élément, de sorte que la direction de spin dans la couche de mémorisation est parallèle, en d'autres termes est dans la même direction, ou antiparallèle, en d'autres termes est dans la direction opposée, par rapport la couche fixe 706.

La figure 7B illustre un élément résistif STT 720 ayant une anisotropie magnétique perpendiculaire au plan. Un tel élément résistif peut par exemple être reprogrammé par un courant d'écriture I inférieur à celui de l'élément 700 pour une taille donnée et/ou pour un volume de couche de mémorisation donné. L'élément 720 est sensiblement cylindrique, et a par exemple une section qui est circulaire. L'élément 720 comprend des électrodes inférieure et supérieure 722 et 724, chacune ayant sensiblement une forme de disque et prenant en sandwich un certain nombre de couches intermédiaires. Les couches intermédiaires comprennent, du bas vers le haut, une couche fixe 726, une barrière d'oxydation 728, et une couche de mémorisation 730. Ces couches sont similaires aux couches correspondantes 706, 708 et 710 de l'élément 700, excepté que la couche fixe 726 et la couche de mémorisation 730 ont une anisotropie perpendiculaire au plan, comme cela est représenté par les flèches verticales dans les couches 726 et 730 de la figure 7B. La couche fixe 726 est illustrée comme ayant une direction de spin allant du bas vers le haut en figure 7B, mais bien-sûr, dans des variantes de réalisation, cette direction de spin pourrait être du haut vers le bas.

Un avantage des modes de réalisation décrits ici est que, en prévoyant un registre dans lequel des données sont fournies en série vers et/ou à partir d'une mémoire non volatile du registre, les données mémorisées par le registre peuvent être sauvegardées et/ou restaurées avec une consommation d'énergie relativement faible tout en conservant un circuit relativement compact.

Avec la description ainsi faite d'au moins un mode de réalisation illustratif, diverses altérations, modifications et améliorations apparaîtront facilement à l'homme de l'art.

Par exemple, bien qu'on ait décrit des exemples dans lesquels chaque cellule de mémoire non volatile comprend deux éléments résistifs, il sera clair pour l'homme de l'art que d'autres agencements de circuit seraient possibles.

En outre, il sera clair pour l'homme de l'art que la tension d'alimentation VDD dans les divers modes de réalisation pourrait être à un niveau quelconque, par exemple être comprise entre 1 et 3 V, et que plutôt que d'être à 0 V, la tension de masse pourrait aussi être considérée comme une tension d'alimentation qui pourrait avoir un niveau quelconque, comme un niveau négatif.

En outre, il sera clair pour l'homme de l'art que, dans tous les modes de réalisation décrits ici, tous les transistors NMOS pourraient être remplacés par des transistors PMOS et/ou tous les transistors PMOS pourraient être remplacés par des transistors NMOS. L'homme de l'art saura facilement comment chacun des circuits pourra être mis en oeuvre en utilisant seulement des transistors PMOS ou seulement des transistors NMOS. En outre, bien qu'on ait décrit ici des transistors basés sur la technologie MOS, dans des variantes de réalisation on pourrait utiliser d'autres technologies de transistors, comme la technologie bipolaire.

En outre, il sera clair pour l'homme de l'art que les divers éléments décrits en relation avec les divers modes de réalisation pourraient être combinés, dans des variantes de réalisation, selon des combinaisons quelconques.

## Revendications

1. Registre comprenant :
une pluralité de cellules de mémoire volatile (104-107) comportant chacune une première entrée et une sortie, les cellules de mémoire volatile étant couplées en série entre elles par l'intermédiaire de leurs premières entrées et de leurs sorties ;
une mémoire non volatile (103) comprenant une pluralité de cellules de mémoire non volatile (204-207) ; et
une ou plusieurs connexions en série (110, 112, 114), dans lequel la mémoire non volatile (103) comprend :
soit une paire de circuits d'écriture commune (222, 224) pour la pluralité de cellules de mémoire non volatile, et un circuit de lecture (228) associé à chacune des cellules de mémoire non volatile (204-207), chaque circuit de lecture ayant sa sortie couplée en parallèle avec l'une correspondante des cellules de mémoire volatile (104-107), l'une ou plusieurs connexions en série étant adaptées à fournir en série à la mémoire non volatile (103) des données à écrire dans la mémoire non volatile (103) à partir d'une dernière ou d'une autre des cellules de mémoire volatile pendant une opération de sauvegarde de données mémorisées par les cellules de mémoire volatile ;
soit un circuit de lecture commun (228) pour la pluralité de cellules de mémoire non volatile (204-207) et une paire de circuits d'écriture (222, 224) associée à chacune des cellules de mémoire non volatile (204-207), chaque circuit d'écriture étant contrôlé sur la base de l'une correspondante des sorties des cellules de mémoire volatile pour programmer une valeur de donnée (D_{V0}-D_{V3}) dans la cellule de mémoire non volatile correspondante, l'une ou plusieurs connexions en série étant adaptées à fournir en série des données lues dans la mémoire non volatile (103) à une première des cellules de mémoire volatile (204) pendant une opération de restauration des données mémorisées par les cellules de mémoire volatile.

2. Registre selon la revendication 1, dans lequel chacune des cellules de mémoire volatile (104-107) comprend en outre une deuxième entrée (D0-D3) pour recevoir des données à mémoriser dans le registre, et une entrée de sélection (SE) pour sélectionner l'une des première et deuxième entrées.

3. Registre selon la revendication 2, comprenant un bloc de commande (116) adapté à contrôler l'entrée de sélection de chacune des cellules de mémoire volatile (104-107) pour sélectionner la première entrée pendant l'opération de restauration et/ou l'opération de sauvegarde.

4. Registre selon l'une quelconque des revendications 1 à 3, dans lequel lesdites une ou plusieurs connexions en série (110, 112, 114) sont en outre adaptées à introduire des données de test par balayage (SCAN_IN) en série dans la première des cellules de mémoire volatile (104) pendant une opération de test par balayage.

5. Registre selon l'une quelconque des revendications 1 à 4, comprenant en outre une ligne de retour (108) couplant la sortie de la dernière des cellules de mémoire volatile (107) à la première entrée de la première des cellules de mémoire volatile (104).

6. Registre selon l'une quelconque des revendications 1 à 5, dans lequel les sorties des cellules de mémoire volatile (104-107) sont couplées en parallèle à des entrées correspondantes (D_{V}, 117) de la mémoire non volatile (103).

7. Registre selon l'une quelconque des revendications 1 à 6, dans lequel lesdites une ou plusieurs connexions en série (112, 114) sont adaptées à fournir les données lues dans la mémoire non volatile (103) en série à la première des cellules de mémoire volatile (204) pendant l'opération de restauration ou à fournir les données à écrire dans la mémoire non volatile (103) en série à partir de la dernière ou d'une autre des cellules de mémoire volatile, à la mémoire non volatile (103) pendant une opération de sauvegarde.

8. Registre selon l'une quelconque des revendications 1 à 7, dans lequel chacune de la pluralité de cellules de mémoire non volatile (204-207) comprend :
des premier et deuxième éléments résistifs (202, 203), dont au moins l'un est programmable pour prendre l'un d'au moins deux états résistifs (Rₘᵢₙ, Rₘₐₓ), une valeur de donnée étant représentée par les résistances relatives des premier et deuxième éléments résistifs, le premier élément résistif (202) étant couplé entre un premier noeud intermédiaire (208) et un premier noeud de mémorisation (230) d'un circuit de lecture (228) et le deuxième élément résistif (203) étant couplé entre un deuxième noeud intermédiaire (212) et un deuxième noeud de mémorisation (232).

9. Registre selon la revendication 8, dans lequel au moins l'un des premier et deuxième éléments résistifs (202, 203) est de l'un des types suivants :
un élément à couple de transfert de spin ayant une anisotropie dans le plan ;
un élément à couple de transfert de spin ayant une anisotropie perpendiculaire au plan ;
un élément à oxydoréduction (RedOx) ;
un élément ferroélectrique ; et
un élément à changement de phase.

10. Procédé de sauvegarde de données dans le registre mémoire de l'une quelconque des revendications 1 à 9, comprenant : fournir en série, par lesdites une ou plusieurs connexions en série (112), des données à écrire dans la mémoire non volatile à partir de la dernière ou d'une autre des cellules de mémoire volatile (104-107).

11. Procédé de restauration de données dans le registre mémoire de l'une quelconque des revendications 1 à 9, comprenant : fournir en série à la première (104) des cellules de mémoire volatile, par lesdites une ou plusieurs connexions en série (114), des données lues dans la mémoire non volatile.

## Patentansprüche

1. Register, das Folgendes aufweist:
eine Vielzahl von flüchtigen Speicherzellen (104-107), die jeweils einen ersten Eingang und Ausgang haben, wobei die flüchtigen Speicherzellen in Reihe miteinander über ihre jeweilige Eingänge und Ausgänge gekoppelt sind;
einen nicht-flüchtigen Speicher (103) der eine Vielzahl von nicht-flüchtigen Speicherzellen (204-207) aufweist; und
eine oder mehrere serielle Verbindungen (110, 112, 114), wobei der nicht-flüchtige Speicher (103) entweder:
ein gemeinsames Paar von Schreibschaltungen (222, 224) für die Vielzahl von nicht-flüchtigen Speicherzellen, sowie eine Leseschaltung (228) aufweist, die mit jeder der nicht-flüchtigen Speicherzellen (204-207) assoziiert ist, wobei der Ausgang jeder Leseschaltung parallel mit einer entsprechenden einen flüchtigen Speicherzellen (104-107) gekoppelt ist, wobei die einen oder mehreren seriellen Verbindungen ausgebildet sind, um seriell Daten, die von einer letzten oder einer anderen der flüchtigen Speicherzellen in den nicht-flüchtigen Speicher (103) geschrieben worden sollen, in den nicht-flüchtigen Speicher (103) während eines Sicherungs- bzw. Backup-Vorgangs der Daten, die in den flüchtigen Speicherzellen gespeichert sind, zu liefern; oder
eine gemeinsame Leseschaltung (228) für die Vielzahl von nicht-flüchtigen Speicherzellen (204-207) und ein Paar von Schreibschaltungen (222, 224) aufweist, die mit jeder der nicht-flüchtigen Speicherzellen (204-207) assoziiert sind, wobei jede Schreibschaltung basierend auf einem entsprechenden einen der Ausgänge der flüchtigen Speicherzellen gesteuert wird, um einen Datenwert (D_{V0}-D_{V3}) in die entsprechende nicht-flüchtige Speicherzelle zu programmieren, wobei die eine oder die mehreren seriellen Verbindungen ausgebildet sind, um seriell Daten, die aus dem nicht-flüchtigen Speicher (103) gelesen wurden, in eine erste der flüchtigen Speicherzellen (204) während eines Wiederherstellungsvorgangs der Daten, die in dem flüchtigen Speicherzellen gespeichert sind, zu liefern.

2. Register nach Anspruch 1, wobei jede der flüchtigen Speicherzellen (104-107) weiter einen zweiten Eingang (D0-D3) aufweist, um Daten zu empfangen, die in dem Register gespeichert werden sollen, und einem Auswahleingang (SE) zum Auswählen von einem der ersten und zweiten Eingängen.

3. Register nach Anspruch 2, das einen Steuerblock (116) aufweist, der ausgebildet ist, um den Auswahleingang von jeder der flüchtigen Speicherzellen (104-107) zu steuern, um den ersten Eingang während des Wiederherstellungs- und/oder Backup-Vorgangs zu wählen.

4. Register nach einem der Ansprüche 1 bis 3, wobei die einen oder mehreren seriellen Verbindungen (110, 112, 114) weiter ausgebildet sind, um Scan-Testdaten (SCAN_IN) in Reihe in die erste flüchtigen Speicherzellen (104) während eines Scan-Testvorgangs einzugeben.

5. Register nach einem der Ansprüche 1 bis 4, welches weiter eine Feedback- bzw. Rückkoppelungsleitung (108) aufweist, die den Ausgang der letzten der flüchtigen Speicherzellen (107) mit dem ersten Eingang der ersten der flüchtigen Speicherzellen (104) koppelt.

6. Register nach einem der Ansprüche 1 bis 5, wobei die Ausgänge der flüchtigen Speicherzellen (104-107) parallel mit entsprechenden Eingängen die (Dv, 117) des nicht-flüchtigen Speichers (103) gekoppelt sind.

7. Register nach einem der Ansprüche 1 bis 6, wobei die eine oder die mehrere seriellen Verbindungen (112, 114) ausgebildet sind, um die Daten, die aus dem nicht-flüchtigen Speicher (103) gelesen wurden, während des Wiederherstellungsbetriebs in Reihe zu der ersten der flüchtigen Speicherzellen (204) zu liefern, oder um die Daten, die in Reihe von der letzten oder einer anderen der flüchtigen Speicherzellen in den nicht-flüchtigen Speicher (103) geschrieben werden sollen, zu dem nicht-flüchtigen Speicher (103) während eines Backup-Vorgangs zu liefern.

8. Register nach einem der Ansprüche 1 bis 7, wobei jede der Vielzahl von nicht-flüchtigen Speicherzellen (204-207) Folgendes aufweist:
erste und zweite resistive Elemente bzw. Widerstandselemente (202, 203), wobei zumindest eines davon programmierbar ist, so dass es einen von mindestens zwei resistiven Zuständen bzw. Widerstandszuständen (Rₘᵢₙ, Rₘₐₓ) hat, wobei ein Datenwert durch die relativen Widerstände der ersten und zweiten Widerstandselemente dargestellt wird, wobei des erste Widerstandselement (202) zwischen einem ersten Zwischenknoten (208) und einem ersten Speicherknoten (230) einer Leseschaltung (228) angeschlossen ist, und wobei das zweite Widerstandselement (203) zwischen einem zweiten Zwischenknoten (212) und einem zweiten Speicherknoten (232) angeschlossen ist.

9. Register nach Anspruch 8, wobei zumindest eines der ersten und zweiten Widerstandselemente (202, 203) eines der Folgenden ist:
ein Spin-Transferdrehmomentelement mit einer Ebenenanisotropie;
ein Spin-Transferdrehmomentelement mit einer Anisotropie senkrecht zur Ebene;
ein Reduktionsoxidations- bzw. Redox-Element;
ein ferro-elektrisches Element; und
ein Phasenänderungselement bzw. Phase-Change-Element.

10. Verfahren zum Backup bzw. zur Sicherung von Daten in dem Speicherregister nach einem der Ansprüche 1 bis 9, welches Folgendes aufweist: serielles Liefern durch die einen oder mehreren seriellen Verbindungen (112) von Daten, die in den nicht-flüchtigen Speicher geschrieben werden sollen, und zwar von der letzten oder einen anderen der flüchtigen Speicherzellen (104-107).

11. Verfahren zum Wiederherstellen von Daten in dem Speicherregister nach einem der Ansprüche 1 bis 9, welches Folgendes aufweist: serielles Liefern durch die eine oder mehreren seriellen Verbindungen (114) von Daten, die aus dem nicht-flüchtigen Speicher gelesen wurden, an die erste (104) der flüchtigen Speicherzellen.

## Claims

1. A register comprising:
a plurality of volatile memory cells (104-107) each having a first input and an output, the volatile memory cells being coupled in series with each other via their first inputs and outputs;
a non-volatile memory (103) comprising a plurality of non-volatile memory cells (204-207); and
one or more serial connections (110, 112, 114), wherein the non-volatile memory (103) comprises either:
a common pair of write circuits (222, 224) for the plurality of non-volatile memory cells, and a read circuit (228) associated with each of the non-volatile memory cells (204-207), each read circuit having its output coupled in parallel to a corresponding one of the volatile memory cells (104-107), the one or more serial connections being adapted to serially supply data to be written to the non-volatile memory (103) from a last or another of the volatile memory cells to the non-volatile memory (103) during a back-up operation of data stored by the volatile memory cells; or
a common read circuit (228) for the plurality of non-volatile memory cells (204-207), and a pair of write circuits (222, 224) associated with each of the non-volatile memory cells (204-207), each write circuit being controlled based on a corresponding one of the outputs of the volatile memory cells to program a data value (D_{V0}-D_{V3}) in the corresponding non-volatile memory cell, the one or more serial connections being adapted to serially supply data read from the non-volatile memory (103) to a first of the volatile memory cells (204) during a restoration operation of the data stored by the volatile memory cells.

2. The register of claim 1, wherein each of the volatile memory cells (104-107) further comprises a second input (D0-D3) for receiving data to be stored in the register, and a selection input (SE) for selecting one of the first and second inputs.

3. The register of claim 2, comprising a control block (116) adapted to control the selection input of each of the volatile memory cells (104-107) to select the first input during the restoration and/or back-up operation.

4. The register of any of claims 1 to 3, wherein the one or more serial connections (110, 112, 114) is further adapted to input scan test data (SCAN_IN) in series to the first of the volatile memory cells (104) during a scan test operation.

5. The register of any of claims 1 to 4, further comprising a feedback line (108) coupling the output of the last of the volatile memory cells (107) to the first input of the first of the volatile memory cells (104).

6. The register of any of claims 1 to 5, wherein the outputs of the volatile memory cells (104-107) are coupled in parallel to corresponding inputs (D_{V}, 117) of the non-volatile memory (103).

7. The register of any of claims 1 to 6, wherein the one or more serial connections (112, 114) are adapted to supply the data read from the non-volatile memory (103) in series to the first of the volatile memory cells (204) during the restoration operation or to supply the data to be written to the non-volatile memory (103) in series from the last or another of the volatile memory cells to the non-volatile memory (103) during a back-up operation.

8. The register of any of claims 1 to 7, wherein each of the plurality of non-volatile memory cells (204-207) comprises:
first and second resistive elements (202, 203), at least one of which is programmable to have one of at least two resistive states (Rₘᵢₙ, Rₘₐₓ), a data value being represented by the relative resistances of the first and second resistive elements, the first resistive element (202) being coupled between a first intermediate node (208) and a first storage node (230) of a read circuit (228) and the second resistive element (203) being coupled between a second intermediate node (212) and a second storage node (232) .

9. The register of claim 8, wherein at least one of said first and second resistive elements (202, 203) is one of:
a spin transfer torque element with in-plane anisotropy;
a spin transfer torque element with perpendicular-to-plane anisotropy;
a reduction oxide (RedOx) element;
a ferro-electric element; and
a phase change element.

10. A method of data back-up in the memory register of any of claims 1 to 9, comprising: serially supplying, by the one or more serial connections (112), data to be written to the non-volatile memory from the last or another of the volatile memory cells (104-107).

11. A method of restoring data in the memory register of any of claims 1 to 9, comprising: serially supplying, by the one or more serial connections (114), data read from the non-volatile memory to the first (104) of the volatile memory cells.
